# FASCICULE DE BREVET EUROPEEN

(11) **EP 2 211 387 B1**
(45) Date de publication et mention de la délivrance du brevet: **10.07.2013**
(21) Numéro de dépôt: 10290025.5
(22) Date de dépôt: 19.01.2010
(51) Int. Cl.: H01L 29/861, H01L 21/329, H01L 29/06, H01L 33/02, H01L 33/18, H01L 29/20, H01L 29/24, H01L 33/28

(54) **Procédé de réalisation d'une homojonction pn dans une nanostructure**
Verfahren zur Herstellung eines homogenen pn-Übergangs in einer Nanostruktur
Method of making a p-n homojunction in a nanostructure

(30) Priorité: 22.01.2009 FR 0900270
(43) Date de publication de la demande: 28.07.2010
(73) Titulaire: Commissariat à l'Énergie Atomique et aux Énergies Alternatives, 75015 Paris (FR)
(72) Inventeur: Romain-Latu, Eddy, 38920 Crolles (FR); Gilet, Philippe, 38470 Têche (FR)
(74) Mandataire: Corret, Hélène

(56) Documents cités:
- WO-A-2004/088755
- US-A1- 2006 006 463
- US-A1- 2006 134 883
- LATU-ROMAIN E; GILET P; FEUILLET G; NOEL P; GARCIA J; LEVY F; CHELNOKOV A: "Optical and electrical characterizations of vertically integrated ZnO nanowires", MICROELECTRONICS JOURNAL, MACKINTOSH PUBLICATIONS LTD. LUTON, GB, vol. 40, no. 2, 19 septembre 2008 (2008-09-19), pages 224-228, XP025925058, ISSN: 0026-2692 [extrait le 2008-09-19]
- LATU-ROMAIN E; GILET P; NOEL P; GARCIA J; FERRET P; ROSINA M; FEUILLET G; LÃ CR VY F; CHELNOKOV A: "A generic approach for vertical integration of nanowires", NANOTECHNOLOGY, IOP, BRISTOL, GB, vol. 19, no. 34, 27 août 2008 (2008-08-27) , page 345304, XP020144499, ISSN: 0957-4484

## Description

L'invention concerne le domaine de l'optoélectronique et en particulier, les émetteurs de rayonnement à semi-conducteur et les photorécepteurs.

La plupart des dispositifs optoélectroniques à base de semi-conducteur intègrent, dans leur partie active, des jonctions p-n.

C'est par exemple le cas des diodes LED (Light Emiting Diode). Ainsi, au contact de deux semi-conducteurs de type n et p, les porteurs de chaque type se recombinent dans la zone active en émettant des photons. La zone active est souvent composée d'un ou de plusieurs puits quantiques qui permettent une grande efficacité de luminescence et un ajustement de la longueur d'onde d'émission, en contrôlant leur composition et leur épaisseur.

Les semi-conducteurs de type n ou p peuvent être obtenus par dopage intrinsèque, classiquement par défaut de stoechiométrie.

Les semi-conducteurs de type n et p peuvent également être obtenus par des dopants extrinsèques qui sont introduits dans la matrice, soit lors de la croissance des matériaux, soit après leur croissance, par des techniques telles que la diffusion ou l'implantation ionique. Il faut cependant noter que, lors de la croissance sur hétérosubstrat, il y a diffusion des atomes légers du substrat (atomes d'Aluminium pour un substrat Al₂O₃) donc dopage extrinsèque, mais il y a souvent des défauts de stoechiométrie (lacunes d'Oxygène par exemple) donc également dopage intrinsèque.

On peut ainsi citer le document WO 2004/088755 qui décrit une nanostructure de type nanofil incorporant des jonctions p-n. Dans un des modes de réalisation décrits, un nanofil est formé sur un substrat puis deux couches d'un matériau polymère sont déposées successivement sur le substrat. La première couche de polymère comprend une concentration donnée de dopants d'un premier type (donneurs par exemple), la deuxième couche comprenant des dopants d'un deuxième type (accepteurs). La structure est ensuite soumise à un traitement thermique approprié de façon à permettre la diffusion des dopants de chacune des deux couches dans deux parties successives du nanofil. Ceci permet de créer une jonction p-n entre les deux parties.

Ainsi, ce document décrit des techniques dites de dopage extrinsèque, dans lesquelles on effectue plus précisément un premier dopage d'un premier type et un deuxième dopage d'un deuxième type.

Dans toute la présente Demande, on comprendra par « dopage extrinsèque » d'une matrice, un dopage réalisé par des dopants de nature différente à ladite matrice et qui sont introduits dans celle-ci lors de la croissance ou depuis un autre matériau.

Ces techniques de dopage de semi-conducteurs présentent certains inconvénients.

En effet, si le dopage extrinsèque est à ce jour bien maîtrisé et contrôlé dans certains semi-conducteurs, comme par exemple, le Silicium (Si) ou l'Arséniure de Gallium (AsGa), ce n'est pas le cas pour d'autres semi-conducteurs, tels que le Nitrure de Gallium (GaN) ou l'Oxyde de Zinc (ZnO). Pour ces derniers, le dopage est parfois difficile ou nécessite des traitements thermiques ou encore des procédés complexes. Par exemple, les techniques de dopage de type p du ZnO ne sont pas actuellement au point. De plus, pour certains semi-conducteurs, le dopage est parfois instable, voire impossible.

Pour pallier ces inconvénients, il a donc été proposé des procédés de réalisation d'une jonction p-n dans une nanostructure, utilisant un seul type de dopage.

Ces procédés s'appuient sur une structure comportant une couche métallique entourée de couches diélectriques pour éviter le transfert de charges électriques à l'extérieur de la couche métallique, la jonction p-n de la nanostructure étant réalisée par polarisation de la couche métallique. Typiquement, il s'agit d'une structure de type transistor réalisable avec une grille dont la polarisation modifie le type de conductivité du canal sous ladite grille et présentant un état passant ou bloquant selon la polarisation de la grille.

La structure est cependant relativement compliquée dans la mesure où elle nécessite le dépôt d'au moins trois couches successives autour du nanofil. De plus, ce procédé nécessite des moyens pour polariser l'élément métallique afin de réaliser la jonction p-n dans la nanostructure.

L'article de Latu-Romain et al. intitulé « Optical and Electrical Characterizations of Vertically Integrated ZnO Nanowires », Microelectronics Journal, Mackintosh Publications LTD., Luton, GB, vol.40(2), pp.224-228, propose également un procédé de réalisation d'une jonction p-n dans une nanostructure, utilisant un seul type de dopage.

Dans un mode de réalisation, il présente l'avantage de ne pas nécessiter de moyen de polarisation externe, tel que l'application d'un champ électrique externe, pour réaliser la jonction p-n.

L'invention a pour objet de proposer un procédé de réalisation d'une jonction p-n, à partir d'une nanostructure ayant un seul type de dopage de type de conductivité donné, nettement simplifié par rapport aux procédés existants et présentant les mêmes avantages que ces derniers.

L'invention concerne un procédé de réalisation d'une jonction p-n dans une nanostructure tel qu'énoncé dans la revendication 1.

L'invention concerne encore un dispositif semi-conducteur tel qu'énoncé dans la revendication 10.

L'invention sera mieux comprise et d'autres buts, avantages et caractéristiques de celle-ci apparaîtront plus clairement à la lecture de la description qui suit et qui est faite au regard des dessins annexés, sur lesquels :
- la figure 1 comprend les figures 1(a) à 1(d) qui représentent différentes étapes de fabrication d'un dispositif semi-conducteur utile à la compréhension de l'invention.
   Les figures 2, 3, 4, et 7 représentent différents types de dispositifs semi-conducteurs utiles à la compréhension de l'invention.
- les figures 5 et 6 représentent, à titre d'exemples non limitatifs, différents types de dispositifs semi-conducteurs selon l'invention ;
- la figure 8 représente la courbure des bandes d'énergie provoquée dans un nanofil, en raison de la présence d'un matériau d'enrobage générant un potentiel de surface Φ_{S}.

Une nanostructure peut généralement être définie comme une structure comportant un ou plusieurs nanoconstituant(s), au moins une des dimensions du ou de chaque nanoconstituant étant de taille nanométrique.

Toutefois, dans le cadre de l'invention, une nanostructure aura un ou plusieurs nanoconstituant(s), chaque nanoconstituant présentant :
- soit deux dimensions de taille nanométrique : on parle alors de nanofil ;
- soit trois dimensions de taille nanométrique : on parle alors de nanoparticule.

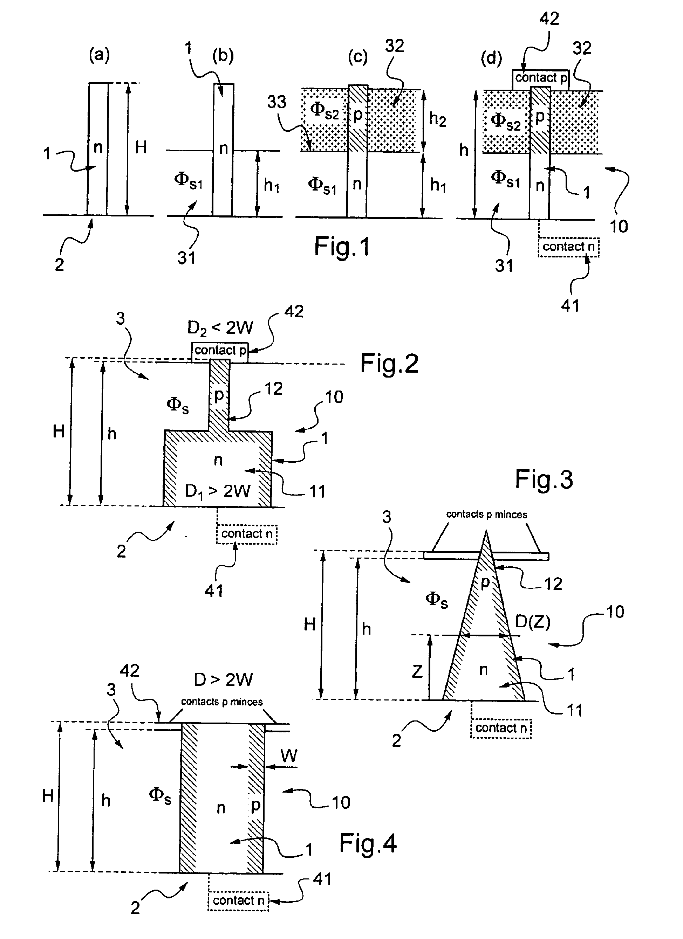

La figure 1 représente par exemple une nanostructure, formée d'un seul nanoconstituant de type nanofil. Le nanofil considéré est de forme cylindrique, et présente un diamètre D qui est typiquement de quelques dizaines à quelques centaines de nanomètres, tandis que sa hauteur H est de l'ordre du micron.

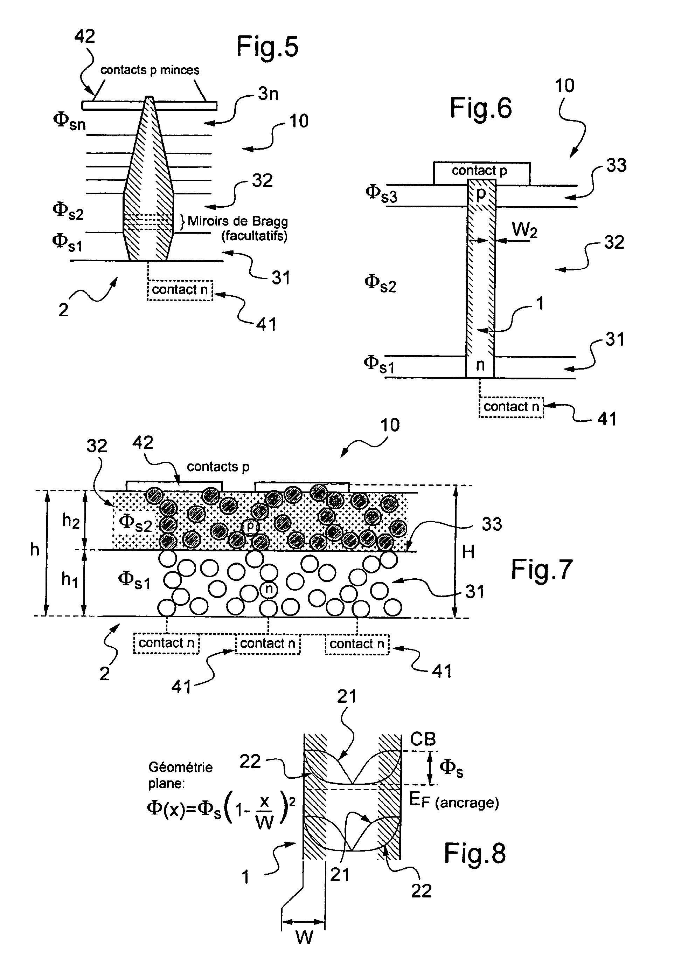

La figure 7 représente quant à elle une nanostructure, formée de plusieurs nanoconstituants de type nanoparticule. II est à noter que dans ce type de nanostructure, on a obligatoirement une pluralité de nanoparticules. Une nanoparticule est assimilable à une sphère, dont le diamètre typique est de quelques dizaines à quelques centaines de nanomètres.

L'invention ne peut pas être mise en oeuvre pour une structure présentant une seule dimension nanométrique. Cette limitation sera expliquée plus en détail dans la suite de la description.

Le dispositif semi-conducteur 10 illustré sur la figure 1 comprend une nanostructure 1 de type nanofil qui a par exemple été obtenue par croissance sur un substrat 2. La croissance du nanofil est par exemple réalisée par MOCVD (pour « Metal Organic Chemical Vapour Deposition » selon la terminologie anglo-saxonne).

Le substrat 2 peut être réalisé en saphir Al₂O₃. Il peut également comporter une couche de quelques dizaines à quelques centaines de nanomètres d'épaisseur, par exemple d'oxyde de zinc ZnO déposé sur le substrat massif d'Al₂O₃. Il peut également être conducteur électrique selon l'application considérée.

De manière générale, l'obtention d'une nanostructure par croissance sur un substrat est largement décrite dans l'Etat de la Technique.

On peut notamment se référer au document WO 2004/088755 précédemment cité qui décrit l'obtention d'un nanofil par croissance sur un substrat. On peut également se référer à l'article paru dans la revue Semiconductor Science and Technology vol. 20, pp S22-S34, en 2005, dont les auteurs sont GC. Yi, C. Wang and WI. Park.

Après l'étape de croissance de la nanostructure 1, celle-ci est dopée avec des porteurs de type n (ou de type p).

En pratique, la nanostructure est généralement dopée lors de la croissance (par ajout d'un dopant au gaz précurseur), mais elle peut l'être également après croissance par diffusion ou implantation ionique.

Les étapes décrites ci-dessus sont connues en soi, et leur mise en oeuvre aboutit par exemple à la structure illustrée sur la figure 1(a), dans le cas d'un nanofil dopé n.

Au cours de tests expérimentaux, la Demanderesse a proposé d'enrober un nanofil tel que représenté sur la figure 1(a) avec un élément diélectrique.

Le nanofil 1 a été enrobé avec un élément diélectrique dont la hauteur h est inférieure à la hauteur H du nanofil.

De ce fait, la face supérieure transversale du nanofil 1 n'est pas enrobée, ce qui permet notamment de pouvoir déposer par la suite un contact métallique au niveau de l'extrémité supérieure du nanofil.

La structure obtenue à l'issue de ces étapes est par exemple représentée sur la figure 4.

Le nanofil 1, présentant une forme cylindrique, présente une dimension transversale assimilable à un diamètre D.

Le nanofil 1 est en oxyde de zinc (ZnO) et l'élément diélectrique choisi est un polymère 3 de type résine novolac, par exemple le polymère accuflo T-27 de la société Honeywell.

Suite à l'étape de formation de l'élément diélectrique, une caractérisation électrique de cette structure a été réalisée par des techniques dérivées de la microscopie atomique.

On a alors pu constater que le polymère 3 génère un potentiel de surface Φ_{S} = 1,9 eV induisant une inversion du type de conductivité sur une largeur W du nanofil 1, prise selon la direction de la dimension transversale du nanofil. Plus précisément, on a pu constater une inversion du type de conductivité sur une largeur W d'environ 90nm pour laquelle la conductivité est de type p. Il y a donc réalisation d'une jonction p-n au sein du nanofil 1.

Par ailleurs, en testant des nanofils de diamètres différents, on a pu constater que la largeur d'inversion W restait constante, à savoir d'environ 90nm dans les conditions d'expérimentation susmentionnées.

Enfin, on a pu constater, pour un diamètre de nanofil inférieur à un diamètre seuil, que l'inversion du type de conductivité s'effectuait sur tout le diamètre du nanofil, ce diamètre seuil étant de l'ordre du double de la largeur d'inversion à savoir ici de l'ordre de 180nm.

Pour obtenir ces résultats expérimentaux, les techniques dites SCM (pour « Scanning Capacitance Microscopy » selon la terminologie anglo-saxonne) et SSRM (pour « Scanning Spread Resistance Microscopy » selon la terminologie anglo-saxonne) ont été employées.

On note que cette jonction p-n est obtenue très simplement, avec la seule présence d'un élément diélectrique enrobant le nanofil, selon une couche unique. La jonction p-n obtenue peut être qualifiée de permanente dans la mesure où il n'y a pas besoin de polariser une couche métallique pour réaliser la jonction p-n.

Le principe illustré expérimentalement ci-dessus peut être généralisé à tout type de matériau d'enrobage susceptible de former une jonction p-n à l'intérieur du nanofil.

A ce titre, on peut envisager différents types de matériaux organiques.

Par exemple, on peut envisager un polymère ou copolymère, aromatique ou non, possédant des systèmes d'électrons π conjugués, par exemple le polystyrène (cycle aromatique C₆H₆) et dérivés, le polynaphtalène (cycle aromatique C₁₀H₈) et dérivés, le polypropylène (cycle aromatique C₁₆H₁₀) et dérivés et/ou des groupements électrophiles, par exemple halogénés. Ces matériaux particulièrement électrophiles sont bien adaptés pour générer une inversion de type p dans la nanostructure, par hydrogénation de la surface du semiconducteur par exemple.

Le matériau enrobant n'est cependant pas exclusivement un matériau polymère.

On peut également prévoir des matériaux inorganiques, tels que des oxydes, par exemple du SiO₂.

En bref, le matériau enrobant peut être élargi à tout type de matériau diélectrique générant par sa seule présence un potentiel de surface approprié, c'est-à-dire susceptible d'inverser le type de conductivité sur une largeur déterminée de la nanostructure.

Le principe illustré expérimentalement ci-dessus pour un nanofil en ZnO peut également être généralisé à tout type de structure comportant un matériau semi-conducteur susceptible de former une jonction p-n.

Par exemple, et non limitativement, le nanofil 1 peut être réalisé en Nitrure de Gallium (GaN), Nitrure d'Aluminium (AIN), Nitrure d'Indium (InN), Sulfure de Cadnium (CdS), Séléniure de Cadnium (CdSe), Tellure de Cadnium (CdTe), Sulfure de Zinc (ZnS), Séléniure de Zinc (ZnSe), Tellure de Zinc (ZnTe), Diséléniure de Cuivre et de Gallium (CuGaSe₂), Disulfure de Cuivre et d'Indium (CuInS₂), Diséléniure de Cuivre et d'Indium (CuInSe₂).

Nous allons décrire plus précisément le procédé en référence à la figure 1.

Ce procédé permet la réalisation d'une jonction p-n dans une nanostructure, ainsi que la réalisation d'une nanostructure avec une jonction p-n pour former un dispositif semi-conducteur.

L'application considérée est celle d'une nanostructure présentant au moins un nanoconstituant de type nanofil 1.

Comme mentionné plus haut, le nanofil 1 présente une hauteur H, et, dans la mesure où il présente une forme cylindrique, la dimension transversale du nanofil 1 correspond au diamètre D de celui-ci.

Après avoir réalisé le nanofil, on forme dans l'étape (b) un premier élément diélectrique 31 de hauteur h₁, enrobant le nanofil 1 sur cette hauteur h₁, en un matériau générant un potentiel de surface Φₛ₁ non apte à inverser le type de conductivité du nanofil ainsi enrobé.

La hauteur du premier élément diélectrique 31 peut par exemple correspondre à la demi-hauteur du nanofil.

L'étape (b) peut être effectuée par centrifugation.

Le cas échéant, une sous-étape de gravure peut être réalisée pour contrôler avec précision la hauteur h₁ du dépôt du premier élément diélectrique 31, et nettoyer la surface du nanofil 1 non recouverte.

Puis, dans l'étape (c), on recouvre le premier élément diélectrique 31 avec un deuxième élément diélectrique 32 de hauteur h₂. Le deuxième élément diélectrique 32 enrobe ainsi le nanofil 1 sur cette hauteur h₂, en un matériau générant un potentiel de surface Φₛ₂ apte à inverser le type de conductivité sur toute la dimension transversale du nanofil.

Le deuxième élément diélectrique 32, et le premier élément diélectrique 31 sont en contact direct. La zone de contact entre les deux éléments diélectriques 31, 32 est référencée 33.

Le deuxième élément diélectrique 32 enrobe le nanofil de forme cylindrique sur l'ensemble de son pourtour. Par suite, on comprend qu'il suffit d'avoir un matériau apte à inverser le type de conductivité sur une demi-dimension transversale du nanofil 1, pour finalement inverser le type de conductivité sur toute la dimension transversale du nanofil.

Ceci est lié à la symétrie de révolution du nanofil 1 autour de son axe de symétrie.

La demi-dimension transversale correspond ainsi au demi-diamètre (ou rayon) du nanofil 1.

Cela signifie que la largeur W de nanofil, prise selon la dimension transversale dudit nanofil, sur laquelle il y a inversion du type de conductivité correspond, au minimum, au rayon du nanofil 1.

La hauteur cumulée h = h₁ + h₂ des éléments diélectriques 31, 32 enrobant le nanofil 1 est inférieure à la hauteur H du nanofil 1. Ceci permet le dépôt ultérieur d'un contact métallique 42 sur le nanofil 1.

Pour cela, l'étape (c), par exemple effectuée par centrifugation, peut être suivie d'une étape de polissage mécano-chimique.

Par ailleurs, la hauteur cumulée h est également supérieure à la grandeur H-W de manière à ce que l'extrémité contactée soit bien en régime d'inversion, sans quoi le contact métallique ne serait pas en contact avec la zone d'inversion.

Les conditions sur la hauteur cumulée h ne remettent pas en cause la création d'une jonction p-n au sein du nanofil.

La centrifugation (également connue sous le terme de « spin coating » dans la terminologie anglo-saxonne) consiste à dispenser un diélectrique sous forme sol-gel sur la nanostructure, puis à mettre en rotation la nanostructure afin d'étendre le diélectrique sur la nanostructure selon une hauteur contrôlée, et enfin à effectuer un recuit pour évaporer les solvants et former le diélectrique solide. Les procédés sol-gel s'appuient sur une polymérisation de précurseurs moléculaires en solution et permettent la production de matériaux vitreux sans recourir à la fusion.

Le polissage mécano-chimique permet un contrôle de la hauteur h₂ de l'élément diélectrique 32. Il est à noter que l'élément diélectrique 32 et le nanofil 1 sont polis en même temps, mais leurs duretés respectives étant différentes, il en résulte une topographie différente.

Finalement, à l'issue de cette étape (c), on a donc réalisé une jonction p-n dans le nanofil 1 dont l'interface (on parle aussi de plan de jonction) s'étend perpendiculairement à l'axe du nanofil 1 : on parle de jonction p-n axiale.

La jonction p-n axiale est réalisée par la seule présence du matériau diélectrique 32 autour du nanofil 1, qui induit, de façon permanente, une inversion du type de conductivité dans le nanofil 1.

Enfin, on réalise une étape (d) de dépôt de contacts métalliques 41, 42 de part et d'autre du nanofil, chacun des deux contacts étant adapté au type de conductivité locale du nanofil, à savoir p ou n.

A l'issue de l'étape (d), on a donc réalisé un dispositif semi-conducteur avec une nanostructure de type nanofil 1 comportant une jonction p-n.

L'étape (b) sert simplement à apporter une isolation électrique autour de la jonction p-n à réaliser, mais n'est pas essentielle pour la formation de la jonction p-n elle-même.

Par ailleurs, selon la nanostructure envisagée, la suppression de l'étape (b) peut être envisagée.

La figure 2 montre par exemple une nanostructure pour laquelle l'étape (b) n'est pas nécessaire.

L'application considérée est celle d'un nanofil présentant deux parties distinctes 11, 12 avec des dimensions transversales distinctes.

La hauteur du nanofil 1 est notée H.

Les deux parties 11, 12 du nanofil 1 considéré sont cylindriques, et présentent un axe de symétrie commun.

La dimension transversale de la première partie 11 peut donc être assimilée à un diamètre, noté D₁. Par suite, la demi-dimension transversale de la première partie 11 correspond au rayon de cette partie 11.

La dimension transversale de la deuxième partie 12 peut également être assimilée à un diamètre, noté D₂. Par suite, la demi-dimension transversale de la deuxième partie 12 correspond au rayon de cette partie 12.

Pour réaliser une jonction p-n dans le nanofil de la figure 2, on met ainsi en oeuvre l'étape (c).

Plus précisément, l'étape (c) consiste alors à former un élément diélectrique 3 de hauteur h, enrobant le nanofil 1 sur cette hauteur h, en un matériau générant un potentiel de surface Φₛ apte à la fois à :
- inverser le type de conductivité sur une largeur (W) strictement inférieure à la demi-dimension transversale de la première partie 11 du nanofil 1 (W<D₁/2); et à
- inverser le type de conductivité sur au moins une demi-dimension transversale de la deuxième partie 12 du nanofil 1 (W > D₂/2).

On comprend que ce résultat peut être obtenu en effectuant un - choix judicieux du matériau diélectrique 3 et/ou des dimensions transversales D₁, D₂ des deux parties 11, 12 du nanofil 1.

Par exemple, pour un nanofil en Oxyde de Zinc (ZnO), on pourra choisir D₁ = 50 nm et D₂ = 150 nm avec un matériau diélectrique 3 comme un polymère de type résine novolac, par exemple le polymère accuflo T-27 de la société Honeywell.

La hauteur h de l'élément diélectrique est telle qu'elle est supérieure à la grandeur H-W de manière à ce que l'extrémité destinée à recevoir un contact soit bien en régime d'inversion.

Là encore, l'étape (c), par exemple effectuée par centrifugation, peut être suivie d'une étape de polissage mécano-chimique pour s'assurer que la hauteur h de l'élément diélectrique 3 est inférieure à la hauteur H du nanofil 1.

Le dépôt d'un contact métallique au niveau de la zone d'inversion pourra alors être réalisé.

On obtient finalement un dispositif semi-conducteur réalisé avec un nanofil comportant une jonction p-n, en réalisant une étape (d) de dépôt des contacts métalliques analogue à celle déjà présentée sur la figure 1(d).

La jonction p-n obtenue est axiale dans la mesure où une partie de l'interface de la jonction s'étend perpendiculairement à l'axe du nanofil 1. La jonction p-n obtenue est également radiale dans la mesure où une autre partie de l'interface de la jonction s'étend parallèlement à l'axe du nanofil 1. La jonction p-n obtenue étant à la fois axiale et radiale, on parle de jonction p-n hybride ou mixte.

Ce type de jonction p-n peut permettre d'améliorer le transport et l'injection électriques des électrons dans la partie de type p pour compenser une densité de porteurs de charges, c'est-à-dire de trous, plus faible dans cette partie.

La jonction p-n mixte est ainsi réalisée par la seule présence du matériau diélectrique 3 autour du nanofil 1, qui induit, par sa seule présence, une inversion permanente du type de conductivité dans le nanofil 1.

La figure 3 illustre une autre variante.

L'application considérée concerne également un nanofil 1 de forme conique.

Le nanofil 1 présente ainsi une forme telle que sa dimension transversale D évolue de manière continue avec la hauteur du nanofil 1.

Contrairement au nanofil représenté sur la figure 2, le nanofil 1 illustré sur la figure 3 ne présente donc pas deux parties distinctes présentant chacune des dimensions transversales D₁, D₂ constantes.

Le nanofil étant de forme conique, une coupe effectuée selon un plan perpendiculaire à l'axe de symétrie du cône, présente la forme d'un cercle.

Ainsi, si z représente une cote le long de l'axe de symétrie du nanofil 1, la dimension transversale du nanofil 1 à cette cote, prise dans un tel plan de coupe, est ainsi défini par D = D(z) où 0 ≤ *z* ≤ *H*. On comprend donc que cette dimension transversale est prise selon un axe perpendiculaire à l'axe de symétrie du nanofil 1.

Par suite, la demi-dimension transversale du nanofil 1 à la cote z correspond au rayon du nanofil 1 à cette cote.

Les étapes de réalisation de la nanostructure illustrée sur cette figure 3 sont similaires à celles de la nanostructure illustrée sur la figure 2.

Pour réaliser une jonction p-n dans le nanofil 1 de la figure 3, on met ainsi en oeuvre l'étape (c).

Plus précisément, l'étape (c) consiste ici à former un élément diélectrique 3 de hauteur h, enrobant le nanofil 1 sur cette hauteur h, en un matériau générant un potentiel de surface Φₛ apte à la fois à :
- inverser le type de conductivité sur une largeur (W) strictement inférieure à la demi-dimension transversale sur une première partie du nanofil 1; et à
- inverser le type de conductivité sur toute la dimension transversale sur une deuxième partie du nanofil 1.

En effet, on distingue bien deux parties 11, 12 dont l'une (partie 11) présente les deux types de conductivité p et n, et dont l'autre (partie 12) ne présente qu'un seul type de conductivité, en l'occurrence p.

La hauteur h de l'élément diélectrique 3 est inférieure à la hauteur H du nanofil 1. La hauteur h est également supérieure à la grandeur H-W.

La forme conique assure la présence d'une dimension transversale faible à une extrémité du nanofil 1 et par suite, l'existence d'une partie d'un seul type de conductivité (partie 12) quelle que soit la nature du matériau enrobant 3.

Une étape de polissage mécano-chimique peut également être effectuée.

On obtient finalement un dispositif semi-conducteur réalisé avec un nanofil 1 comportant une jonction p-n, en réalisant une étape (d) de dépôt des contacts métalliques analogue à celles des variantes illustrées sur les figures 1 ou 2.

La jonction p-n ainsi réalisée est notamment avantageuse pour améliorer l'extraction de la lumière dans le cas de la réalisation de LED par exemple.

Là encore, la jonction p-n est réalisée par la seule présence du matériau diélectrique 3 autour du nanofil 1, qui induit, par sa seule présence, une inversion permanente du type de conductivité dans le nanofil 1.

La figure 4 illustre également une variante pour laquelle l'étape (b) de la figure 1 n'est pas nécessaire.

L'application considérée est celle d'un nanofil 1 de forme cylindrique présentant ainsi une dimension transversale constante sur toute sa hauteur.

La dimension transversale correspond donc au diamètre D du cylindre formé par le nanofil 1.

La demi-dimension transversale correspond alors au rayon du nanofil 1.

La mise en oeuvre de l'étape (c) permet de conduire à une jonction p-n dans un nanofil 1, analogue à celle de la première partie 11 du nanofil 1 illustré sur la figure 2.

Plus précisément, l'étape (c) consiste ici à inverser le type de conductivité sur une largeur (W) strictement inférieure à la demi-dimension transversale du nanofil 1 (W < D/2) sur toute la hauteur dudit nanofil.

Là encore, l'étape (c), par exemple effectuée par centrifugation, peut être suivie d'une étape de polissage mécano-chimique pour s'assurer que la hauteur h de l'élément diélectrique 3 est inférieure à la hauteur H du nanofil 1. De plus, la hauteur h est là encore supérieure à la grandeur H-W.

Enfin, pour réaliser le dispositif semi-conducteur avec un nanofil comportant une jonction p-n, on met en oeuvre l'étape (d).

La jonction p-n peut être qualifiée de radiale. En effet, l'interface entre les zones p et n s'étend parallèlement à la direction de l'axe de symétrie du nanofil.

Cette nanostructure permet notamment d'augmenter la surface de recombinaison des porteurs de chaque type, l'interface entre les deux zones p et n étant relativement importante et par suite, d'augmenter le rendement quantique de la nanostructure, l'émission de photons étant plus importante.

Le dépôt de contacts métalliques de cette étape (d) diffère cependant de celles prévues pour les jonctions p-n des figures 1 à 3.

En effet, le contact métallique 42 prévu pour la zone p (n respectivement) de la jonction p-n doit être annulaire et mince pour ne pas être en contact avec la zone n (p respectivement) de la jonction p-n du nanofil 1.

Sa forme et sa hauteur doivent donc être contrôlées avec précision.

De plus, on préférera mettre en oeuvre l'étape de polissage mécano-chimique pour faciliter l'étape (d).

Il faut en effet que la surface sur laquelle on dépose le contact soit la plus uniforme possible, sinon un dépôt d'une couche mince, de hauteur bien maîtrisée, pour former le contact métallique est susceptible de ne pas aboutir au résultat recherché.

La jonction p-n radiale est réalisée par la seule présence du matériau diélectrique 3 autour du nanofil 1, qui induit, par sa seule présence, une inversion permanente du type de conductivité dans le nanofil 1.

La figure 5 illustre une première variante de réalisation de l'invention.

L'application considérée est celle d'un nanofil 1 avec une forme symétrique de révolution et présentant une dimension transversale D variant de façon continue en fonction de sa hauteur.

Contrairement à la variante de réalisation illustrée sur la figure 3, la forme n'est cependant pas conique.

En effet, en faisant varier les paramètres de croissance lors de la croissance du nanofil, une grande variété de formes peut être obtenue, comme cela est exposé dans Z.L. Wang, Materialstoday, 26 juin 2004 pour un nanofil en ZnO.

Si z représente une cote le long de l'axe de symétrie du nanofil 1, la dimension transversale du nanofil 1 à cette cote z est alors définie dans un plan perpendiculaire à cet axe de symétrie, comme le diamètre du nanofil à cette cote.

La dimension transversale s'écrit donc D = D(z) où 0 ≤ *z* ≤ *H*. Par suite, la demi-dimension transversale du nanofil 1 à la cote z correspond au rayon du nanofil 1 à cette cote.

Cette variante reprend les étapes (c) et (d) de la figure 4.

Toutefois, l'étape (c) est ici répétée n fois de suite, avec n éléments diélectriques 31, 32, ..., 3n enrobant chacun le nanofil 1 sur une partie distincte de celui-ci et générant respectivement un potentiel de surface Φ _{S1}, Φ_{S2}, ..., Φ_{Sn} distinct l'un de l'autre.

L'étape (c) consiste alors à effectuer les sous-étapes suivantes :
- on forme, lors d'une étape (c₁), un premier élément diélectrique 31, enrobant le nanofil sur une première hauteur h₁, en un matériau générant un potentiel de surface Φₛ₁ apte à inverser le type de conductivité du nanofil sur une première largeur déterminée W₁ selon la dimension transversale du nanofil ;
- on forme, lors d'une étape (c₂), un deuxième élément diélectrique 32, enrobant une partie distincte du nanofil 1 de celle enrobée par le premier élément diélectrique 31, sur une hauteur h₂ du nanofil, en un matériau générant un potentiel de surface Φₛ₂ apte à inverser le type de conductivité du nanofil ainsi enrobé sur une deuxième largeur déterminée W₂ selon la dimension transversale du nanofil;
- etc...
- on forme, lors d'une étape (cₙ), un n^{ème} élément diélectrique 3n, enrobant une n^{éme} partie du nanofil, sur une hauteur hₙ du nanofil, en un matériau générant un potentiel de surface Φₛₙ apte à inverser le type de conductivité du nanofil ainsi enrobé sur une n^{éme} largeur déterminée Wₙ selon la dimension transversale du nanofil.

A l'issue de la sous-étape (cₙ), et avant l'étape (d), on peut effectuer un polissage mécano-chimique du matériau enrobant 3n.

La hauteur cumulée h = h₁ + h₂ + ...+ hₙ des n matériaux enrobants 31, 32, ..., 3n est inférieure à la hauteur H du nanofil et supérieure à la grandeur H-W, où W représente la largeur d'inversion Wₙ, en vue du dépôt ultérieur du contact métallique.

Enfin, pour réaliser le dispositif semi-conducteur avec un nanofil comportant une jonction p-n, l'étape (d) est analogue à celle conduisant au dispositif semi-conducteur illustré sur la figure 4.

La jonction p-n peut être qualifiée de radiale. En effet, l'interface entre la zone p et la zone n s'étend parallèlement à la direction de l'axe de symétrie du nanofil.

La nanostructure représentée sur la figure 5 permet d'ajuster les propriétés de transport et d'injection électriques et les propriétés optiques dans la nanostructure, afin d'améliorer le rendement quantique (émission de photons) et l'extraction de ces photons.

De plus, pour certaines applications, on peut prévoir une étape de réalisation de miroirs de Bragg, de préférence lors de l'étape (a).

Une nouvelle fois, la jonction p-n est réalisée par la seule présence du matériau diélectrique 3 autour du nanofil 1, qui induit, par sa seule présence, une inversion permanente du type de conductivité dans le nanofil 1.

La figure 6 illustre une deuxième variante de réalisation de l'invention.

L'application considérée est celle d'un nanofil 1 avec une forme cylindrique, présentant une dimension transversale assimilable à un diamètre D.

Cette variante reprend les étapes (c) et (d) de la figure 4.

Toutefois, l'étape (c) est ici répétée trois fois de suite, avec trois éléments diélectriques 31, 32, 33 enrobant chacun le nanofil 1 sur une partie distincte de celui-ci et générant respectivement un potentiel de surface Φ _{S1}, Φ_{S2}, Φ_{S3} distinct l'un de l'autre.

L'étape (c) consiste alors à effectuer les sous-étapes suivantes :
- on forme, lors d'une étape (c₁), un premier élément diélectrique 31, enrobant le nanofil sur une première hauteur h₁, en un matériau non apte à inverser le type de conductivité du nanofil ;
- on forme, lors d'une étape (c₂), un deuxième élément diélectrique 32, enrobant une partie du nanofil 1 distincte de celle enrobée par le premier élément diélectrique 31, sur une hauteur h₂ du nanofil, en un matériau générant un potentiel de surface Φₛ₂ apte à inverser le type de conductivité du nanofil ainsi enrobé sur une largeur déterminée W₂ selon la dimension transversale du nanofil;
- on forme, lors d'une étape (c₃), un troisième élément diélectrique 33, enrobant une troisième partie du nanofil, sur une hauteur h₃ du nanofil, en un matériau générant un potentiel de surface Φₛ₃ apte à inverser le type de conductivité du nanofil ainsi enrobé sur toute la dimension transversale du nanofil.

A l'issue de la sous-étape (c₃), et avant l'étape (d), on peut effectuer un polissage mécano-chimique du matériau enrobant 33.

La hauteur cumulée h = h₁ + h₂ + h₃ des trois matériaux enrobants 31, 32, 33 est inférieure à la hauteur H du nanofil et supérieure à la grandeur H-W, où W représente la largeur d'inversion W₃.

Enfin, pour réaliser le dispositif semi-conducteur avec un nanofil comportant une jonction p-n, l'étape (d) est analogue à celle conduisant au dispositif semi-conducteur illustré sur la figure 4.

La nanostructure représentée sur la figure 6 permet une bonne injection des porteurs dans les zones n et p respectivement, et offre une grande zone de recombinaison définie par l'interface p-n.

Une nouvelle fois, la jonction p-n est réalisée par la seule présence de matériaux diélectriques 32, 33 autour du nanofil 1, qui induisent, par leur seule présence, une inversion permanente du type de conductivité dans le nanofil 1.

Dans tous les modes de réalisation décrits ci-dessus, on a présenté une nanostructure comportant un seul nanoconstituant de type nanofil.

L'homme du métier comprendra que les étapes réalisées pour un seul nanofil peuvent être mises en oeuvre pour une nanostructure comportant une pluralité de nanofils disposés les uns à côté des autres.

Dans ce cas, les étapes (c), (d) et éventuellement (b) s'appliquent en même temps à cette pluralité de nanofils.

La figure 7 illustre le cas où la nanostructure ne présente pas un ou des nanoconstituant(s) de type nanofil, mais une pluralité de nanoconstituants de type nanoparticule.

Chaque nanoparticule peut être assimilée à une sphère de diamètre D. La dimension transversale d'une nanoparticule peut donc être définie par son diamètre D. Par suite, la demi-dimension transversale de cette nanoparticule peut être assimilée au rayon de la nanoparticule.

Plus précisément, la nanostructure est formée d'une pluralité de nanoconstituants de type nanoparticule, présentant des propriétés de confinement quantique.

Par confinement quantique, on entend que le déplacement des électrons ou des trous est limité dans au moins une direction. Cette propriété est liée à la taille des nanoparticules par comparaison au rayon de Bohr.

Les nanoparticules sont en contact les unes avec les autres, de sorte à assurer un contact électrique.

Les nanoparticules définissent ensemble une nanostructure de hauteur notée H.

Ces nanoparticules peuvent être formées par différents procédés. En effet, il est envisageable d'utiliser un procédé dérivé du procédé PLD (pour « Pulsed Laser Déposition » selon la terminologie anglo-saxonne), un procédé par pyrolyse laser ou des méthodes chimiques (M. L. Kahn et al., Adv. Func. Mater. 2005, 15, 458).

Le procédé de réalisation d'une jonction p-n dans une telle nanostructure, et le procédé de réalisation d'un dispositif semi-conducteur associé à cette nanostructure reprennent les étapes (b), (c) et (d) illustrées sur la figure 1.

Plus précisément, on forme lors d'une étape (b), un premier élément diélectrique 31 de hauteur h₁, enrobant la pluralité de nanoparticules sur une première partie de la nanostructure de hauteur h₁, en un matériau générant un potentiel de surface Φₛ₁ non apte à inverser le type de conductivité des nanoparticules comprises dans cette première partie.

Puis, on recouvre, lors d'une étape (c), le premier élément diélectrique 31 avec un deuxième élément diélectrique 32 de hauteur h₂. Le deuxième élément diélectrique 32 enrobe ainsi une deuxième partie de la nanostructure sur cette hauteur h₂, en un matériau générant un potentiel de surface Φₛ₂ apte à inverser le type de conductivité sur toute la dimension transversale des nanoparticules comprises dans cette deuxième partie.

L'inversion du type de conductivité dans le nanofil 1 est permanente et obtenue par la seule présence de l'élément diélectrique enrobant les nanoparticules.

Les deux parties de la nanostructure sont en contact direct au niveau d'un plan de contact 33.

La hauteur cumulée h = h₁ + h₂ des éléments diélectriques 31, 32 est inférieure à la hauteur H de la nanostructure et supérieure à la grandeur H-W, en vue du dépôt du contact métallique. Certaines nanoparticules dépassent donc partiellement des parties de la nanostructure enrobées par les éléments diélectriques 31, 32. Ceci permet le dépôt ultérieur d'au moins un contact métallique 42 sur la nanostructure.

Pour assurer la continuité électrique, il suffit alors qu'il existe un contact entre :
- le contact 42 (p),
- quelques nanoparticules de type p,
- quelques nanoparticules de type n, et
- le contact 41 (n).

L'étape (c) peut par exemple être effectuée par centrifugation, et peut être suivie d'une étape de polissage mécano-chimique.

A l'issue de cette étape (c), on a donc réalisé une jonction p-n dans la nanostructure.

Enfin, on réalise une étape (d) de manière analogue à celle illustrée sur la figure 2 pour réaliser le dispositif semi-conducteur.

Comme nous l'avons déjà mentionné, les procédés présentés ne peuvent pas être mis en oeuvre pour une structure présentant une seule dimension nanométrique.

Autrement dit, ces procédés ne peuvent s'appliquer qu'à des nanostructures présentant un ou plusieurs nanoconstituant(s) avec au moins deux dimensions nanométriques.

Pour mieux comprendre cette condition, la figure 8 représente un calcul théorique fournissant l'évolution du potentiel 21 selon une dimension transversale (diamètre D) d'un nanofil 1 auquel est appliqué un potentiel de surface Φ_{S}.

Le potentiel au sein du nanofil 1 décroît très lentement sur une largeur W du nanofil, cette largeur étant définie selon la direction transversale du nanofil (W < D). Cette largeur W correspond à la largeur de nanofil sur laquelle on constate une inversion du type de conductivité.

Sur cette figure 8, on a ajouté l'évolution du potentiel 22, toujours selon une dimension transversale, d'une structure plane à laquelle est également appliqué un potentiel de surface Φ_{S}. Ce type de structure ne présente qu'une seule dimension nanométrique.

On constate ici que le potentiel diminue très rapidement lorsqu'on pénètre à l'intérieur de la structure plane. La largeur sur laquelle on constate une inversion du type de conductivité est donc très faible, cette largeur étant définie selon la direction de la dimension transversale de la structure plane.

Plus précisément, on peut montrer que la largeur sur laquelle le type de conductivité est inversé est 8 à 10 fois plus importante pour un nanofil que pour une structure plane, toutes choses égales par ailleurs.

Pour cette raison, une inversion du type de conductivité selon l'invention sur une structure plane est difficilement envisageable, parce que la largeur d'inversion du type de conductivité sera trop faible pour permettre la réalisation d'une jonction p-n au sein même de la structure.

Au contraire, les nanostructures considérées dans le cadre de l'invention le permettent. De plus, le choix d'un matériau diélectrique enrobant adéquat et/ou, selon le mode de réalisation, d'une dimension transversale adaptée du nanoconstituant, permet(tent) de déterminer la largeur de nanoconstituant sur laquelle l'on souhaite réaliser une inversion du type de conductivité.

Une autre façon de définir la condition d'application de l'invention est de préciser que l'invention ne peut être mise en oeuvre que pour des nanostructures présentant un ou plusieurs nanoconstituant(s) avec un rapport surface/volume élevé.

Pour donner un ordre de grandeur, on pourra considérer qu'un rapport surface/volume est élevé lorsqu'il dépasse une valeur seuil de 10⁶m⁻¹.

Avec une structure plane, on comprend que le rapport surface/volume peut être qualifié de faible.

Nous avons présenté ci-dessus deux modes de réalisation de l'invention.

Pour tous ces modes, nous avons défini une hauteur de nanostructure, une dimension transversale de nanoconstituant, et une largeur d'inversion du type de conductivité de ce nanoconstituant.

Dans tous les cas, la largeur W d'inversion est une dimension s'étendant selon la direction de la dimension transversale du nanoconstituant considéré.

## Revendications

1. Procédé de réalisation d'une jonction p-n dans une nanostructure (1), dans lequel la nanostructure (1) présente un ou plusieurs nanoconstituant(s) comportant au moins deux dimensions nanométriques et réalisé(s) en un matériau semi-conducteur présentant un seul type de dopage présentant un type de conductivité, , **caractérisé en ce qu'**il comprend plusieurs étapes consistant à former, sur des parties distinctes de la nanostructure, un élément diélectrique enrobant la nanostructure, les éléments diélectriques ainsi formés (31, 32,..., 3n) générant des potentiels de surface distincts (Φₛ₁, Φₛ₂,..., Φₛₙ), aptes à inverser le type de conductivité sur des largeurs distinctes du ou des nanoconstituant(s) ainsi enrobé(s) d'une partie à l'autre de la nanostructure

2. Procédé de réalisation d'une jonction p-n dans une nanostructure selon la revendication 1, dans lequel, préalablement à l'étape de formation de l'élément diélectrique, on forme un autre élément diélectrique (31) enrobant la nanostructure (1) en un matériau non apte à inverser le type de conductivité du ou des nanoconstituant(s) ainsi enrobé(s).

3. Procédé de réalisation d'une jonction p-n dans une nanostructure selon l'une des revendications précédentes, dans lequel, pour former l'élément diélectrique, on choisit un matériau générant un potentiel de surface inversant le type de conductivité sur une largeur au moins égale à la demi-dimension transversale du ou des nanoconstituant(s) ainsi enrobé(s).

4. Procédé de réalisation d'une jonction p-n dans une nanostructure selon l'une des revendications 1 à 2, dans lequel, pour former l'élément diélectrique, on choisit un matériau générant un potentiel de surface inversant le type de conductivité sur une largeur strictement inférieure à la demi-dimension transversale du ou des nanoconstituant(s) ainsi enrobé(s).

5. Procédé de réalisation d'une jonction p-n sur une nanostructure selon l'une des revendications 1 à 2, dans lequel, on forme l'élément diélectrique (3) sur une nanostructure présentant au moins un nanoconstituant de type nanofil (1) dont la dimension transversale diffère lorsqu'on se déplace dans le sens de sa hauteur, de sorte que ledit élément diélectrique (3) génère, sur une première partie (11) du nanofil (1), un potentiel de surface inversant le type de conductivité du nanofil sur une largeur (W) strictement inférieure à la demi-dimension transversale du nanofil et génère, sur une autre partie (12) du nanofil, un potentiel de surface inversant le type de conductivité du nanofil (1) sur une largeur au moins égale à la demi-dimension transversale du nanofil.

6. Procédé de réalisation d'une jonction p-n dans une nanostructure selon l'une des revendications 1 à 3, dans lequel la nanostructure présente une pluralité de nanoconstituants de type nanoparticule.

7. Procédé de réalisation d'une jonction p-n dans une nanostructure selon l'une des revendications 1 à 5, dans lequel la nanostructure présente un ou plusieurs nanoconstituant(s) de type nanofil.

8. Procédé de réalisation d'une nanostructure avec au moins une jonction p-n dans lequel réalisée selon la revendication 1, le dopage est extrinsèque comprenant en outre la formation de contacts métalliques (41, 42) de part et d'autre de la nanostructure (1), chacun des deux contacts étant adapté au type de conductivité locale de la nanostructure.

9. Procédé de réalisation d'une nanostructure avec au moins une jonction p-n selon la revendication 8, comprenant en outre une étape consistant, pour une nanostructure présentant au moins un nanoconstituant de type nanofil, à :
- former l'un des contacts métallique avec une hauteur au plus égale à la différence entre la hauteur H du nanofil et la hauteur h du ou des élément(s) diélectrique(s) enrobant le nanofil.

10. Dispositif semi-conducteur comprenant au moins une nanostructure avec au moins une jonction p-n et présentant un ou plusieurs nanoconstituant(s) comportant au moins deux dimensions nanométriques et réalisé(s) en un matériau ayant un seul type de dopage extrinsèque, **caractérisé en ce qu'**il comprend :
- plusieurs éléments diélectriques (3, 32, ..., 3n) enrobant la nanostructure (1) sur des parties distinctes de la nanostructure, les éléments diélectriques ainsi formés générant des potentiels de surface distincts Φₛ₁, Φₛ₂,..., Φₛₙ) aptes à inverser le type de conductivité sur des largeurs distinctes du ou des nanoconstituant(s) ainsi enrobé(s) d'une partie à l'autre de la nanostructure ; et
- des contacts métalliques (41, 42) de part et d'autre de la nanostructure (1), chacun des deux contacts étant adapté au type de conductivité locale de la nanostructure.

11. Dispositif semi-conducteur selon la revendication 10, dans lequel la nanostructure présente une pluralité de nanoconstituants de type nanoparticule, lesdites nanoparticules étant en contact entre elles.

12. Dispositif semi-conducteur selon l'une des revendications 10 ou 11, dans lequel l'élément diélectrique apte à inverser le type de conductivité sur une largeur déterminée du ou des nanoconstituant(s) est un matériau organique tel qu'un polymère possédant des électrons π conjugués et/ou des groupements électrophiles, par exemple halogénés.

13. Dispositif semi-conducteur selon la revendication précédente, dans lequel l'élément diélectrique est un polymère choisi parmi le polystyrène ou ses dérivés, le polynaphtalène ou ses dérivés, le polypropylène ou ses dérivés.

14. Dispositif semi-conducteur selon l'une des revendications 10 ou 11, dans lequel l'élément diélectrique apte à inverser le type de conductivité sur une largeur déterminée du ou des nanoconstituant(s) est un matériau inorganique tel qu'un oxyde.

## Patentansprüche

1. Verfahren zur Realisierung eines p-n-Übergangs in einer Nanostruktur (1), wobei die Nanostruktur (1) einen oder mehrere Nanobestandteil(e) aufweist, welche(r) wenigstens zwei Abmessungen im Nanometerbereich aufweist/aufweisen und aus einem Halbleitermaterial realisiert ist/sind, welches einen einzigen Dotierungstyp mit einem Leitungstyp aufweist, **dadurch gekennzeichnet, dass** es mehrere Schritte umfasst, welche darin bestehen, auf verschiedenen Teilen der Nanostruktur ein dielektrisches Element auszubilden, welches die Nanostruktur umhüllt, wobei die so gebildeten dielektrischen Elemente (31, 32,..., 3n) verschiedene Oberflächenpotentiale (Φₛ₁, Φₛ₂..., Φₛₙ) erzeugen, welche dazu geeignet sind, den Leitungstyp auf verschiedenen Breiten des so umhüllten Nanobestandteils bzw. der so umhüllten Nanobestandteile von einem Teil zu dem anderen der Nanostruktur umzukehren.

2. Verfahren zur Realisierung eines p-n-Übergangs in einer Nanostruktur nach Anspruch 1, wobei vor dem Schritt zur Ausbildung des dielektrischen Elements ein weiteres die Nanostruktur (1) umhüllendes dielektrisches Element (31) aus einem Material ausgebildet wird, welches nicht geeignet ist, den Leitungstyp des so umhüllten Nanobestandteils bzw. der so umhüllten Nanobestandteile umzukehren.

3. Verfahren zur Realisierung eines p-n-Übergangs in einer Nanostruktur nach einem der vorhergehenden Ansprüche, wobei zur Ausbildung des dielektrischen Elements ein Material ausgewählt wird, welches ein Oberflächenpotential erzeugt, das den Leitungstyp auf einer Breite umkehrt, welche mindestens gleich dem transversalen Halbmesser des so umhüllten Nanobestandteils bzw. der so umhüllten Nanobestandteile ist.

4. Verfahren zur Realisierung eines p-n-Übergangs in einer Nanostruktur nach einem der Ansprüche 1-2, wobei zur Ausbildung des dielektrischen Elements ein Material ausgewählt wird, welches ein Oberflächenpotential erzeugt, dass den Leitungstyp auf einer Breite umkehrt, welche streng kleiner als der transversale Halbmesser des so umhüllten Nanobestandteils bzw. der so umhüllten Nanobestandteile ist.

5. Verfahren zur Realisierung eines p-n-Übergangs auf einer Nanostruktur nach einem der Ansprüche 1-2, wobei das dielektrische Element (3) auf einer Nanostruktur ausgebildet wird, welche wenigstens einen Nanobestandteil vom Typ eines Nanodrahts (1) aufweist, dessen transversale Abmessung entlang der Richtung seiner Höhe derart differiert, dass das dielektrische Element (3) auf einem ersten Teil (11) des Nanodrahts (1) ein Oberflächenpotential erzeugt, welches den Leitungstyp des Nanodrahts auf einer Breite (W) umkehrt, welche streng kleiner als der transversale Halbmesser des Nanodrahts ist, und auf einem anderen Teil (12) des Nanodrahts ein Oberflächenpotential erzeugt, welches den Leitungstyp des Nanodrahts (1) auf einer Breite umkehrt, welche wenigstens gleich dem transversalen Halbmesser des Nanodrahts ist.

6. Verfahren zur Realisierung eines p-n-Übergangs in einer Nanostruktur nach einem der Ansprüche 1-3, wobei die Nanostruktur eine Vielzahl von Nanobestandteilen vom Typ eines Nanopartikels aufweist.

7. Verfahren zur Realisierung eines p-n-Übergangs in einer Nanostruktur nach einem der Ansprüche 1-5, wobei die Nanostruktur einen oder mehrere Nanobestandteil(e) vom Typ eines Nanodrahts aufweist.

8. Verfahren zur Realisierung einer Nanostruktur mit wenigstens einem p-n-Übergang, welcher nach dem Anspruch 1 realisiert ist, wobei die Dotierung extrinsisch ist, umfassend außerdem die Ausbildung von metallischen Kontakten (41, 42) auf beiden Seiten der Nanostruktur (1), wobei jeder der zwei Kontakte an den lokalen Leitungstyp der Nanostruktur angepasst ist.

9. Verfahren zur Realisierung einer Nanostruktur mit wenigstens einem p-n-Übergang nach Anspruch 8, umfassend außerdem einen Schritt, welcher für eine Nanostruktur mit wenigstens einem Nanobestandteil vom Typ eines Nanodrahts darin besteht:
. metallische Kontakte mit einer Höhe auszubilden, welche höchstens gleich der Differenz zwischen der Höhe H des Nanodrahts und der Höhe h des den Nanodraht umgebenden dielektrischen Elements bzw. der den Nanodraht umgebenden dielektrischen Elemente ist.

10. Halbleitervorrichtung, umfassend wenigstens eine Nanostruktur mit wenigstens einem p-n-Übergang und mit einem oder mehreren Nanobestandteil(en), welche wenigstens zwei Abmessungen im Nanometerbereich aufweisen und aus einem Material realisiert ist/sind, welches einen einzigen extrinsischen Dotierungstyp aufweist, **dadurch gekennzeichnet, dass** sie umfasst:
. mehrere dielektrische Elemente (3, 32,..., 3n), welche die Nanostruktur (1) auf verschiedenen Teilen der Nanostruktur umhüllen, wobei die so gebildeten dielektrischen Elemente verschiedene Oberflächenpotentiale Φₛ₁, Φₛ₂,..., Φₛₙ) erzeugen, welche dazu geeignet sind, den Leitungstyp auf verschiedenen Breiten des so umhüllten Nanobestandteils bzw. der so umhüllten Nanobestandteile von einem Teil von dem anderen der Nanostruktur umzukehren; und
. metallische Kontakte (41, 42) auf beiden Seiten der Nanostruktur (1), wobei jeder der zwei Kontakte an den lokalen Leitungstyp der Nanostruktur angepasst ist.

11. Halbleitervorrichtung nach Anspruch 10, wobei die Nanostruktur eine Vielzahl von Nanobestandteilen vom Typ eines Nanopartikels aufweist, wobei die Nanopartikel miteinander in Kontakt sind.

12. Halbleitervorrichtung nach einem der Ansprüche 10 oder 11, wobei das dielektrische Element, welches dazu ausgestaltet ist, den Leitungstyp auf einer bestimmten Breite des Nanobestandteils bzw. der Nanobestandteile umzukehren, ein organisches Material ist, wie zum Beispiel ein Polymer, welches konjugierte Π-Elektronen und/oder elektrophile Gruppen, wie zum Beispiel halogenierte, aufweist.

13. Halbleitervorrichtung nach dem vorhergehenden Anspruch, wobei das dielektrische Element ein Polymer ist, welches ausgewählt ist aus Polysterol oder seinen Derivaten, Polynaphtalin oder seinen Derivaten, Polypropylen oder seinen Derivaten.

14. Halbleitervorrichtung nach einem der Ansprüche 10 oder 11, wobei das dielektrische Element, welches dazu geeignet ist, den Leitungstyp auf einer bestimmten Breite des Nanobestandteils bzw. der Nanobestandteile umzukehren, ein anorganisches Material ist, wie zum Beispiel ein Oxid.

## Claims

1. A method of producing a p-n junction in a nanostructure (1), in which the nanostructure (1) has one or more nanoconstituents having at least two nanoscale dimensions and made of a semiconductor material with a single type of doping having one conductivity type, the method being **characterized in that** it includes a plurality of steps consisting in forming a dielectric element embedding the nanostructure, the dielectric elements (31, 32, ..., 3n) thus formed generating different surface potentials (Φₛ₁, Φₛ₂, ..., Φₛₙ) capable of inverting the conductivity type over different widths of the nanoconstituents(s) thus embedded from one portion of the nanostructure to another.

2. A method of producing a p-n junction in a nanostructure according to claim 1, wherein, prior to the step of forming the dielectric element, another dielectric element (31) embedding the nanostructure (1) is formed from a material not capable of inverting the conductivity type of the nanoconstituent(s) thus embedded.

3. A method of producing a p-n junction in a nanostructure according to either preceding claim, wherein, in order to form the dielectric element, a material is chosen that generates a surface potential inverting the conductivity type over a width at least equal to the transverse half-dimension of the nanoconstituent(s) thus embedded.

4. A method of producing a p-n junction in a nanostructure according to claim 1 or claim 2, wherein, in order to form the dielectric element, a material is chosen that generates a surface potential inverting the conductivity type over a width strictly less than the transverse half-dimension of the nanoconstituent (s) thus embedded.

5. A method of producing a p-n junction in a nanostructure according to claim 1 or claim 2, wherein, the dielectric element (3) is formed on a nanostructure having at least one nanowire type nanoconstituent (1), the transverse dimension of which differs upon moving in its height direction, so that said dielectric element (3) generates, on a first portion (11) of the nanowire (1), a surface potential inverting the conductivity type of the nanowire over a width (W) strictly smaller than the transverse half-dimension of the nanowire and generates, on another portion (12) of the nanowire, a surface potential inverting the conductivity type of the nanowire (1) over a width at least equal to the transverse half-dimension of the nanowire.

6. A method of producing a p-n junction in a nanostructure according to any one of claims 1 to 3, wherein the nanostructure has a plurality of nanoconstituents of the nanoparticle type.

7. A method of producing a p-n junction in a nanostructure according to any one of claims 1 to 5, wherein the nanostructure has one or more nanoconstituents of the nanowire type.

8. A method of producing a nanostructure with at least one p-n junction produced according to claim 1, wherein the doping is extrinsic, the method further including the forming of metal contacts (41, 42) on either side of the nanostructure (1), each of the two contacts being matched to the local conductivity type of the nanostructure.

9. A method of producing a nanostructure with at least one p-n junction according to claim 8, further including a step consisting, for a nanostructure having at least one nanoconstituent of the nanowire type, in:
· forming one of the metal contacts with a height at most equal to the difference between the height H of the nanowire and the height h of the dielectric element(s) embedding the nanowire.

10. A semiconductor device, comprising at least one nanostructure with at least one p-n junction and having one or more nanoconstituents including at least two nanometric dimensions and made of a material having a single type of extrinsic doping, **characterized in that** it includes:
· a plurality of dielectric elements (3, 32, ..., 3n), embedding the nanostructure (1) over different portions of the nanostructure, the dielectric elements (31, 32, ..., 3n) thus formed generating different surface potentials (Φₛ₁, Φₛ₂, ..., Φₛₙ) capable of inverting the conductivity type over different widths of the nanoconstituents(s) thus embedded from one portion of the nanostructure to another; and
· metal contacts (41, 42) on either side of the nanostructure (1), each of the two contacts being matched to the local conductivity type of the nanostructure.

11. A semiconductor device according to claim 10, wherein the nanostructure has a plurality of nanoconstituents of the nanoparticle type, said nanoparticles being in contact with one another.

12. A semiconductor device according to claim 10 or claim 11, wherein the dielectric element capable of inverting the conductivity type over a defined width of the nanoconstituent(s) is an organic material such as a polymer having conjugated π electrons and/or electrophilic groups, for example halogen groups.

13. A semiconductor device according to the preceding claim, wherein the dielectric element is a polymer chosen from polystyrene or its derivatives, polynaphthalene or its derivatives and polypyrene or its derivatives.

14. A semiconductor device according to claim 10 or claim 11, wherein the dielectric element capable of inverting the conductivity type over a defined width of the nanoconstituent (s) is an inorganic material, such as an oxide.
